# EUROPÄISCHE PATENTANMELDUNG

(11) **EP 4 067 280 A1**
(43) Veröffentlichungstag der Anmeldung: **05.10.2022**
(21) Anmeldenummer: 22162536.1
(22) Anmeldetag: 16.03.2022
(51) Int. Cl.: B66B 1/46, H03K 17/96

(54) **SCHALTERANORDNUNG FÜR EINEN AUFZUG, INSBESONDERE EIN PERSONEN- UND/ODER WARENAUFZUG**

(30) Priorität: 30.03.2021 CH 3302021
(71) Anmelder: EMCH Aufzüge AG, 3027 Bern (CH)
(72) Erfinder: TÜRLER, Daniel, 3067 Boll (CH); ZURFLÜH, Thomas, 3032 Hinterkappelen (CH)
(74) Vertreter: Luchs, Willi

(57) **Zusammenfassung**

Eine Schalteranordnung für einen Aufzug, vorzugsweise ein Personen- oder Warenaufzug, weist vorzugsweise mehrere beschriftete Drucktasten (11) und eine elektrische Leiterverbindung (21) mit einer Steuerungseinrichtung des Aufzugs auf. Die Schalteranordnung (10) ist jeweils mit wenigstens einem elastisch verformbaren Plattenelement (20) mit den-Drucktasten (11) mit der oberseitigen Beschriftung des Tastenfeldes und mit einem unterhalb dieses Plattenelementes (20) der wenigstens einen Drucktaste (11) zugeordnetes Erkennungselement (24) der Biegung im Tastenfeld versehen. Zudem ist diese elektrische Leiterverbindung (21) von den Erkennungselementen (24) zur Steuerungseinrichtung vorgesehen. Damit können dünnere und bedienerfreundlichere Schalteranordnungen in oder ausserhalb eines Aufzugs insbesondere für die Ansteuerung derselben oder für allgemeine Funktionen eingebaut werden.

## Beschreibung

Die Erfindung betrifft eine Schalteranordnung für einen Aufzug, vorzugsweise ein Personen- oder Warenaufzug, welche vorzugsweise mehrere jeweils ein Tastenfeld bildende Drucktasten und wenigstens eine elektrische Leiterverbindung mit einer Steuerungseinrichtung des Aufzugs aufweist, dies nach dem Oberbegriff des Anspruchs 1.

Bei einer Schalteranordnung gemäss der Druckschrift EP-A-3 018 826 zum Steuern einer Vorrichtung, wie zum Beispiel eines elektrischen Verbrauchers, ist eine Schnittstelle mit einer Vielzahl von Schaltflächen vorgesehen, die mittels eines insbesondere manuell aufbringbaren Fingerdrucks betätigbar sind. Beim einem während eines Einwirkens der Betätigungskraft auf eine Schaltfläche wird durch einen elektromechanischen Wandler eine mechanische in eine elektrische Energiemenge umgewandelt. Es ist einer Anzeigevorrichtung eine visuelle Markierung der Schaltfläche im Wesentlichen stromlos darstellbar. Die visuelle Markierung ist in Abhängigkeit von der mittels des elektromechanischen Wandlers erzeugbaren elektrische Energiemenge änderbar. Eine Betätigungskraft bewirkt eine elastische Verformung einer Overlayschicht und der benachbart dazu angeordneten Anzeigevorrichtung. Ein Kontaktelement dient zum elektrischen Kontaktieren der Leiterbahn, über welche infolge der Betätigungskraft die elektrische Energiemenge schliesslich zu einem Mikrocontroller oder anderen Steuer- bzw. Schaltelektronik weitergeleitet wird.

Der Erfindung liegt die Aufgabe zugrunde, eine gattungsmässige Schalteranordnung für einen Aufzug derart zu gestalten, dass sie bei robuster Bauweise auf sehr einfache und platzsparende Weise im oder beim Aufzug primär für seine Steuerung einbaubar ist und sich damit neue Gestaltungsmöglichkeiten ihres Einbaus ergeben.

Erfindungsgemäss ist die Aufgabe durch die Merkmale des Anspruchs 1 gelöst.

Die Schalteranordnung umfasst jeweils wenigstens ein elastisch verformbares Plattenelement mit der wenigstens einen Drucktaste, ein unterhalb dieses Plattenelementes jeder Drucktaste zugeordnetes Erkennungselement der Biegung im Tastenfeld und diese elektrische Leiterverbindung des jeweiligen Erkennungselementes mit der Steuerungseinrichtung.

Damit können erfindungsgemäss gegenüber den herkömmlichen bedeutend dünnere und bedienerfreundlichere Schalteranordnungen in oder ausserhalb der Aufzüge insbesondere für die Ansteuerung derselben oder für allgemeine Funktionen eingebaut werden.

So können diese Schalteranordnungen nach der Erfindung sehr vorteilhaft in einem ohnehin im Aufzug befindlichen Handlauf bei der einen oder bei beiden Seitenwänden und/oder bei der Rückseite integriert sein.

Zweckmässigerweise ist jeweils ein Modul zumindest mit dem dünnen Plattenelement mit mehreren Drucktasten mit der oberseitigen Markierung der Tastenfelder, den Erkennungselementen und den elektrischen Leitern vorgesehen. Ein solches Modul lässt sich einfach in einem Handlauf in der Aufzugkabine ohne grossen Platzbedarf so montieren, dass die Bedienerfreundlichkeit durch ihre Zugänglichkeit in Griffhöhe optimal verwirklicht ist.

Die Erfindung sowie weitere Vorteile derselben sind nachfolgend anhand von Ausführungsbeispielen unter Bezugnahme auf die Zeichnung näher erläutert. Es zeigt:
- Fig. 1: eine perspektivisch und teilweise im Schnitt dargestellte erfin-dungsgemässe Schalteranordnung an einem Handlauf mit rechteckigem Querschnitt; und
- Fig. 2: eine Variante einer perspektivisch und teilweise im Schnitt dar-gestellten erfindungsgemässen Schalteranordnung an einem Handlauf mit rundem Querschnitt.

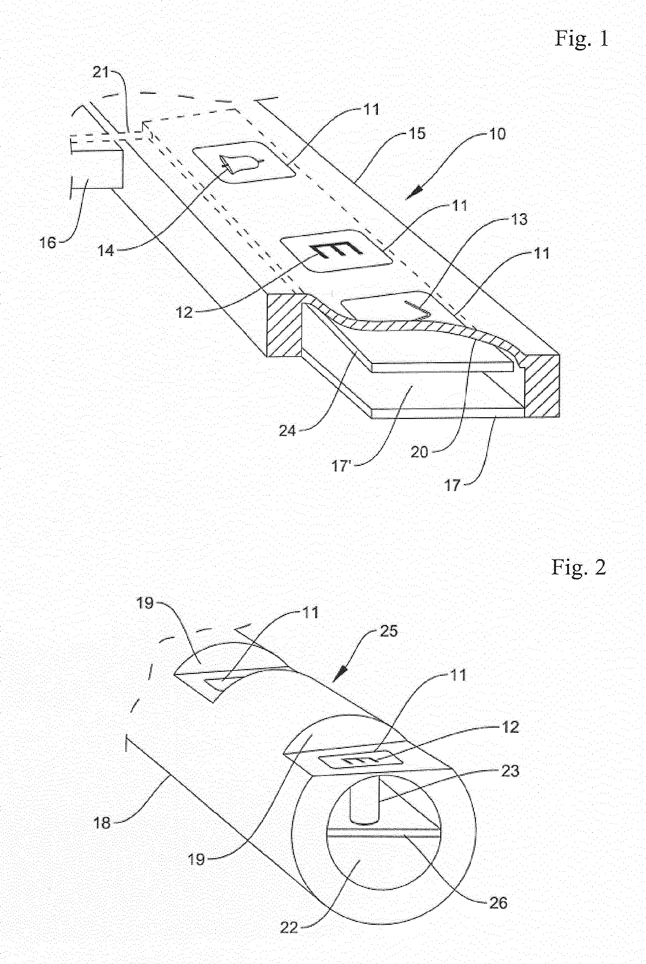

Fig. 1 zeigt eine Schalteranordnung 10 für einen nicht näher gezeigten Aufzug insbesondere zum Transportieren von Personen, Tiere oder Waren aller Art. Es handelt sich um einen handelsüblichen Lift mit einer oder mehreren Kabinen, welcher in beliebigen Grössen und Gewichtskapazitäten und beliebigen Formen gebaut sein kann. Zudem kann er in allen Arten von Gebäuden, Stationen oder an Aussenstellen installiert sein. Der Aufzug weist dabei für die notwendigen Funktionen eine bekannte Steuerungseinrichtung als Kommandozentrale auf, welche mitunter von der Schalteranordnung 10 durch ihre Drucktasten 11 ansteuerbar ist.

Die Drucktasten 11 bilden jeweils ein Tastenfeld mit einer üblichen Grösse annähernd eines Daumenabdrucks, die aber variieren kann. Sie sind dabei rechteckig, quadratisch, rund, elliptisch und/oder andersförmig ausgebildet. Zudem sind diese Drucktasten 11 in und/oder neben ihren Tastenfeldern jeweils mit einer Beschriftung durch wenigstens eine Zahl 13, ein Zeichen 14, einen Buchstaben 12, ein Wort und/ oder irgend ein Zeichen beschriftet. Sie könnten aber auch ohne Beschriftung und nur durch eine Randlinie an ihrem Aussenumfang oder anderweitig markiert sein. Damit wird das Anzeigen zum Beispiel eines gewünschten Stockwerks des Aufzugs (12, 13), einer Alarmtaste (14), je einer Auf- und Zu-Taste für die Türe, einer Aussenruf-Taste und/oder von Tasten für andere Funktionen ermöglicht.

Erfindungsgemäss sind die Drucktasten 11 jeweils in wenigstens einem elastisch verformbaren Plattenelement 20 des jeweiligen Tastenfeldes enthalten und es sind unterhalb dieses Plattenelementes 20 jeder Drucktaste 11 jeweils ein Erkennungselement 24 für die Feststellung der Biegung im Tastenfeld zugeordnet.

Damit kann die eine oder die mehreren Drucktasten 11 mit dem wenigstens einen Plattenelement 20 und dem Erkennungselement 24 mit einer dünnen Gesamtschichtdicke bemessen sein, die ein paar Millimeter, maximal zwischen 3 und 10 Millimetern, betragen können.

Sehr vorteilhaft sind den Erkennungselementen 24 spezifisch ausgebildete Dehnungsmessstreifen und eine entsprechende Auswerteeinheit zugeordnet, die durch steckbare elektrische Leiter 21 mit der Steuerungseinrichtung verbindbar sind. Mit solchen Dehnungsmessstreifen kann diese dünne Dicke der Erkennungselemente 24 erzielt werden, welche vorzugsweise als Chipkarten bzw. Leiterplatten ausgebildet sind.

Die wirksamen Tastenfelder 11' der Drucktasten 11 sind jeweils durch eine Randlinie 21 an ihrem Aussenumfang, durch eine andere Farbe, ein unterschiedliches Material als ausserhalb der Tastenfelder 11' und/oder eine andere Kennzeichnung des zu berührenden Tastenfeldes 11' begrenzt.

Die Schalteranordnung 10 ist bevorzugt in wenigstens einem Handlauf 15 integriert, der zum Beispiel in der Kabine befestigt ist. Sie kann aber auch an einem wandseitigen Schalttableau oder dergleichen platziert sein. Es ist in Fig. 1 das eine vorzugsweise vorne bei der Kabinentüre befindliche Ende dieses rechteckförmigen Handlaufs 15 schematisch veranschaulicht, der durch Querleisten 16 oder ähnlichem an einer Seitenwand in der Kabine in vorgegebener Griffhöhe befestigt ist. Dieser Handlauf 15 dient für einen Benutzer zum Festhalten oder einer Führung von Hand. Die elektrische Leiterverbindung 21 ist vom Handlauf 15 durch diese Querleiste 16 in die Wandung und von dort zur Steuerungseinrichtung des Aufzugs geführt, welche sich üblicherweise in einem stationären Steuerraum neben dem Aufzugsschacht befindet, damit sie jederzeit zugänglich ist. Selbstverständlich könnten auch mehr als eine elektrische Leiterverbindung 21 vorgesehen sein.

Es ist ferner noch ein lösbar befestigter Deckel 17 auf der Unterseite des Handlaufs 15 vorgesehen, der für die Montage bzw. Reparaturen der Schalteranordnung und für den Zugang der elektrischen Leiterverbindung 21 dient. Zudem ist ein Hohlraum 17' zwischen dem Deckel 17 und dem plattenförmigen Erkennungselement 24 für die elektrischen Kabel oder dergleichen vorgesehen.

Zweckmässigerweise sind das Plattenelement 20 mit den Drucktasten 11, das Erkennungselement 24 und der Anschluss an die Leiterverbindung 21 als ein Modul ausgebildet. Solche Module können vorgefertigt als Leiterplatten bzw. Chipkarten sein und in dem Aufzug einfach an der entsprechenden Stelle eingebaut werden. Dieser rechteckförmige Teil des Handlaufs 15 könnte auch frontseitig bei einem im Querschnitt üblicherweise runden Handlauf befestigt oder aufgesteckt sein.

Bei einem Aufzug für grössere Gebäude mit mehreren Stockwerken könnten auch mehrere durch elektrische Leiter direkt oder mittels Steckern miteinander verbindbare Module mit jeweils insbesondere mehreren Drucktasten aneinandergereiht sein.

Das Plattenelement 20 mit den Drucktasten 11 ist vorzugsweise aus einem metallenen biegsamen Werkstoff hergestellt, welches derart mit dem Erkennungselement 24 verbunden ist, dass bei einem üblichen Tastendruck mit einer Kraft zwischen 1 Newton und max. 5 Newton auf das Plattenelement 20 der Dehnungsmessstreifen gebogen und von diesem folglich ein Messsignal durch eine Signalübertragung an die Steuerungseinrichtung des Aufzugs gesendet wird. Es kann bei dieser Schalteranordnung 10 vorgesehen sein, dass ein akustisches Signal und/oder Aufleuchten bei Erkennen des Tastendrucks generiert und vom Bediener als Bestätigung hörbar und/oder sichtbar ist. Dieses Plattenelement 20 mit den Drucktasten 11 kann auch aus einem mehrschichtigen Material oder aus einem Kunststoff bestehen.

Im Gegensatz zu Touch Screens besteht dabei der weitere Vorteil, dass diese Drucktasten 11 auch beim Tragen von Handschuhen oder für behinderte Personen mit Prothesen der Finger genausogut betätigt werden können, wenn ein Tastendruck mit ausreichender Druckkraft erzeugt wird.

Mit Vorteil sind die Drucktasten 11 in dem Plattenelement 20 durch diese einzige Platte ohne Spalten bei ihren Umrandungen und ohne irgendwelche Absätze ausgebildet. Damit kann die Schalteranordnung mit starken Reinigungsmitteln oder mit Wasserhochruck gereinigt werden, ohne dass sie undicht wird, und sie ist vor einem missbräuchlichen Beschädigen geschützt.

Fig. 2 zeigt eine Schalteranordnung 25 eines Aufzugs, die in einem mit einem runden Querschnitt geformten Handlauf 18 integriert ist. Sie ist an sich gleich wie diejenige nach Fig. 1 ausgestaltet. Es sind daher nachfolgend nurmehr die Unterschiede erläutert. Es ist das eine vorzugsweise vorne bei der Kabinentüre befindliche Ende dieses stangen- oder rohrförmigen Handlaufs 18 schematisch veranschaulicht. Dieser Handlauf 18 ist ebenfalls durch Querleisten oder ähnlichem an einer Seiten- oder Rückwand in der Kabine in vorgegebener Griffhöhe befestigt. Es sind zwei voneinander separierte Drucktasten 11 gezeigt. Es könnten aber auch mehr als zwei von diesen vorgesehen sein.

Erfindungsgemäss sind die Drucktasten 11 jeweils in einem elastisch verformbaren Plattenelement mit der oberseitigen Beschriftung des jeweiligen Tastenfeldes enthalten und es ist unterhalb dieses Plattenelementes der jeweiligen Drucktaste 11 ein Erkennungselement 26 für die Feststellung der Biegung im Tastenfeld zugeordnet. Das Erkennungselement 26 kann als ein Modul für die beiden Drucktasten 11 ausgebildet sein.

Da das Erkennungselement 26 annähernd im Zentrum im Innern des Handlaufs 18 angeordnet ist, ist ein mechanisches Kopplungsstück 23 für die Überbrückung des Abstandes zwischen ihm und dem aussenseitigen Plattenelement mit dem Drucktaster 11 angeordnet. Damit erfolgt bei einem Tastendruck eine Übertragung der Biegung vom Drucktaster via dieses Kopplungsstück 23 auf das Erkennungselement 26. Zudem ist in dem gebildeten Hohlraum 22 im Handlauf 18 die nicht gezeigte elektrische Leiterverbindung geführt. Mit diesem konstruktiven Aufbau ist ein einwandfreies Funktionieren dieser Schalteranordnung 25 gewährleistet und es lässt sich mit dem rohrförmigen Handlauf 18 eine einfache Konstruktion bewerkstelligen.

Die beiden Drucktasten 11 sind jeweils in einer segmentförmigen als Nute ausgebildeten Tasche 19 enthalten. Damit kann sichergestellt werden, dass diese beim Berühren bzw. dem Festhalten des Handlaufs 18 nicht versehentlich gedrückt werden.

Die Erfindung zeichnet sich noch dadurch aus, dass auf dem Plattenelement 20 ein beliebiges Dekorband vorzugsweise mit dem oder den dargestellten Tastenfeldern aufgebracht werden kann, zum Beispiel ein Leder- oder ein Stoffband, ein Holzfurnier, eine Glasplatte oder ähnliche Werkstoffe. Damit ergeben sich diese vielfältigen Gestaltungsvarianten der Schalteranordnungen im Kontext mit der Ausgestattung des Kabinendesigns.

Dieser im Querschnitt runde Handlauf 18 ist vorzugsweise mit einem Aussendurchmesser von 35 bis 45 Millimetern bemessen und dies ist ausreichend, dass im Bereich der Schalteranordnung keine Veränderung seines Querschnittes notwendig ist.

Die mit der Steuerungseinrichtung des Aufzugs durch die elektrischen Leiter 21 verbundenen Erkennungselemente der Drucktasten 11 sind mit einer Stromversorgung bei einer Spannung von vorzugsweise 3V bis 24V versehen, damit beim Drücken der Drucktasten und damit der Verbiegung der Dehnungsmessstreifen der sich ändernde elektrische Widerstand in ihnen einwandfrei festgestellt werden kann.

Die Erfindung ist mit den oben erläuterten Ausführungsbeispielen ausreichend dargetan. Sie könnte aber noch durch weitere Varianten erläutert sein. So könnten bei den Erkennungselementen anstelle von Dehnungsmessstreifen ebenso piezoelektrische Sensoren oder ähnliches verwendet werden. Das Plattenelement könnte auch im Bereich der Tastenfelder mit einer dünneren Dicke dimensioniert sein, um ihre Biegsamkeit zu erhöhen.

Bei Verwendung eines Handlauf kann dieser den gezeigten runden oder eckigen oder auch einen andersförmigen Querschnitt, wie mehreckig, oval oder eckig mit abgerundeten Ecken aufweisen.

Die elektrische Leiterverbindung 21 kann vom Handlauf 15 durch diese Querleiste oder durch andere Durchgänge in die Wandung und von dort zur Steuerungseinrichtung des Aufzugs geführt werden, welche sich üblicherweise in einem stationären Steuerraum neben dem Aufzugsschacht befindet, damit sie jederzeit zugänglich ist.

Diese Schalteranordnung nach der Erfindung könnte genauso in einer Wand in der Kabine oder aussen im Bereich der Türumrandung für eine Bedienung bei einem Anfordern der Kabine auf ein bestimmtes Stockwerk platziert sein.

## Patentansprüche

1. Schalteranordnung für einen Aufzug, vorzugsweise ein Personen- oder Warenaufzug, welche vorzugsweise mehrere jeweils ein Tastenfeld bildende Drucktasten (11) und wenigstens eine elektrische Leiterverbindung (21) mit einer Steuerungseinrichtung des Aufzugs aufweist, **dadurch gekennzeichnet, dass**
die Schalteranordnung (10, 25) jeweils mit wenigstens einem elastisch verformbaren Plattenelement (20) mit der mindestens einen Drucktaste (11), mit einem unterhalb dieses Plattenelementes (20) der wenigstens einen Drucktaste (11) zugeordnetes Erkennungselement (24, 26) der Biegung im Tastenfeld, vorzugsweise ein Dehnungsmessstreifen, und mit der elektrischen Leiterverbindung (21) des jeweiligen Erkennungselementes (24, 26) mit der Steuerungseinrichtung des Aufzugs versehen ist.

2. Schalteranordnung nach Anspruch 1, **dadurch gekennzeichnet, dass**
diese eine oder die mehreren Drucktasten (11) mit dem wenigstens einen Plattenelement (20) und dem Erkennungselement (24) mit einer dünnen Gesamtschichtdicke vorzugsweise im Millimeterbereich bemessen sind.

3. Schalteranordnung nach Anspruch 2, **dadurch gekennzeichnet, dass**
die Schalteranordnung (10, 25) für ihre Bedienung in wenigstens einem Handlauf (15, 18) im oder neben dem Aufzug integriert ist und die elektrische Leiterverbindung (21) vom Handlauf (15, 18) zur Steuerungseinrichtung des Aufzugs geführt ist, wobei dieser Handlauf (15, 18) für einen Benutzer zum Festhalten oder Führen dient und mit einem runden, eckigen oder andersförmigen Querschnitt versehen ist.

4. Schalteranordnung nach einem der Ansprüche 1 bis 3, **dadurch gekennzeichnet, dass**
ein Modul zumindest mit dem Plattenelement (20) mit mehreren Drucktasten (11) mit der vorzugsweise oberseitigen Beschriftung der Tastenfelder, den Erkennungselementen (24, 26) und der elektrischen Leiterverbindung (21) gebildet ist.

5. Schalteranordnung nach Anspruch 1, **dadurch gekennzeichnet, dass**
ein mechanisches Kopplungsstück (23) für die Überbrückung des Abstandes zwischen dem aussenseitigen Plattenelement mit dem Drucktaster (11) und dem Erkennungselement (26) angeordnet ist, durch welches bei einem Tastendruck eine Übertragung der Biegung vom Drucktaster via dieses Kopplungsstück (23) auf das Erkennungselement (26) erfolgt.

6. Schalteranordnung nach einem der Ansprüche 1 bis 5, **dadurch gekennzeichnet, dass**
dem jeweiligen Erkennungselement (24, 26) ein spezifisch ausgebildeter Dehnungsmessstreifen und eine entsprechende Auswerteeinheit zugeordnet ist, die durch steckbare elektrische Leiterverbindung (21) mit der Steuerungseinrichtung verbindbar ist.

7. Schalteranordnung nach einem der Ansprüche 1 bis 6, **dadurch gekennzeichnet, dass**
die Drucktasten (11) jeweils mit Beschriftungen durch wenigstens eine Zahl (13), ein Zeichen (14) und/ oder einen Buchstaben (12) für ihr Anzeigen eines gewünschten Stockwerks des Aufzugs, einer Alarmtaste, je einer Auf- und Zu-Taste für die Türe, einer Aussenruf-Taste und/oder von Tasten für andere Funktionen bestückt sind.

8. Schalteranordnung nach einem der Ansprüche 1 bis 7, **dadurch gekennzeichnet, dass**
auf dem Plattenelement ein Dekorband vorzugsweise mit dem oder den dargestellten Tastenfeldern aufgebracht ist, zum Beispiel ein Leder- oder ein Stoffband, ein Holzfurnier, eine Glasplatte oder ähnliche Werkstoffe.

9. Schalteranordnung nach einem der Ansprüche 1 bis 8, **dadurch gekennzeichnet, dass**
das jeweilige mit der Steuerungseinrichtung des Aufzugs durch Leiter verbundene Erkennungselement (24, 26) der Drucktasten (11) mit einer Stromversorgung bei einer Spannung von vorzugsweise 3V bis 24V versehen ist, um die Dehnungen messen zu können.

10. Schalteranordnung nach einem der Ansprüche 1 bis 9, **dadurch gekennzeichnet, dass**
die vorzugsweise mehreren Drucktasten in dem Modul durch eine einzige Platte ohne Spalten bei ihren Umrandungen und ohne irgendwelche Absätze für ein missbräuchliches Beschädigen derselben ausgebildet sind.

11. Schalteranordnung nach einem der Ansprüche 1 bis 10, **dadurch gekennzeichnet, dass**
die wirksamen Tastenfelder (11') der Drucktasten (11) jeweils durch eine Randlinie (21) an ihrem Aussenumfang, durch eine andere Farbe, ein unterschiedliches Material als ausserhalb der Tastenfelder (11') und/oder eine andere Kennzeichnung des zu berührenden Tastenfeldes (11') begrenzt sind.

12. Schalteranordnung nach einem der Ansprüche 1 bis 11, **dadurch gekennzeichnet, dass**
die vorzugsweise mehreren Drucktasten derart in oder an einem gegenständlichen Teil des Aufzugs dicht eingebaut sind, dass sie mit starken Reinigungsmitteln oder mit Wasserhochruck reinigbar sind.
